# FASCICULE DE BREVET EUROPEEN

(11) **EP 3 815 158 B1**
(45) Date de publication et mention de la délivrance du brevet: **24.01.2024**
(21) Numéro de dépôt: 19748855.4
(22) Date de dépôt: 26.06.2019
(51) Int. Cl.: H10K 71/13, H10K 85/10, H10K 71/15

(54) **COMPOSITION DE POLYMÈRE CONDUCTEUR ET SON PROCÉDÉ DE FABRICATION**
LEITFÄHIGE POLYMERZUSAMMENSETZUNG UND VERFAHREN ZUR HERSTELLUNG DAVON
CONDUCTIVE POLYMER COMPOSITION AND METHOD FOR PRODUCING SAME

(30) Priorité: 29.06.2018 FR 1856060
(43) Date de publication de la demande: 05.05.2021
(73) Titulaire: Dracula Technologies, 26000 Valence (FR); Centre national de la recherche scientifique, 75016 Paris (FR); Université d'Aix Marseille, 13007 Marseille (FR)
(72) Inventeur: PIERRON, Pascal, 26100 ROMANS SUR ISERE (FR); BEN DKHIL, Sadok, 26000 VALENCE (FR); MARGEAT, Olivier, 13008 MARSEILLE (FR); ACKERMANN, Jörg, 13008 MARSEILLE (FR)
(74) Mandataire: Novagraaf Technologies
(86) Numéro de dépôt international: PCT/FR2019/051573
(87) Numéro de publication internationale: WO 2020/002832

(56) Documents cités:
- EP-A1- 2 391 186
- WO-A1-2015/189494
- US-A1- 2014 000 700
- T. M. EGGENHUISEN ET AL.: "High efficiency, fully inkjet printed organic solar cells with freedom of design", J.MATER.CHEM.A, vol. 3, 11 février 2015 (2015-02-11), pages 7255-7262, XP002789546,

## Description

La présente invention concerne de manière générale une composition de polymère conducteur, son procédé de réalisation et une structure comprenant une telle composition. Cette composition est par exemple utilisée pour la réalisation de cellules photovoltaïques organiques (usuellement désignées par l'acronyme anglais OPC pour « *Organic Photovoltaic Cells* »)*.*

Par cellule photovoltaïque organique, on entend, au sens de la présente invention, cellules photovoltaïques dont au moins la couche active est constituée de matériaux organiques.

Les cellules organiques représentent un véritable intérêt dans le domaine du photovoltaïque. En effet, la possibilité de substituer les semi-conducteurs organiques généralement utilisés dans les cellules photovoltaïques permet d'accroître le nombre de systèmes réalisables et donc les possibilités d'utilisation. Le développement des cellules organiques photovoltaïques, et plus encore le développement de cellules organiques photovoltaïques commercialisables représentent à l'actuelle un enjeu majeur.

Ces dernières années, le développement des cellules organiques photovoltaïques a connu une évolution par l'utilisation de la technique d'impression par jet d'encre pour leur mise en oeuvre ^{[1], [2]}. D'ailleurs, le Demandeur a mis au point en 2014 un procédé de fabrication de cellules photovoltaïques utilisant cette technique pour l'impression d'une partie des couches de ces cellules ^{[3]} .

Une publication de 2015 fait même mention de cellules photovoltaïques obtenues intégralement par la technique d'impression par jet d'encre. ^{[5]}

De nombreuses études se sont alors focalisées sur la réalisation de couches interfaciales par application par voie liquide comme les techniques d'impression en rouleau, ou d'impression par centrifugation (ou « *spin coating* » en anglais), ou par application par impression par jet d'encre d'une encre comprenant un mélange polymère de poly(3,4-éthylènedioxythiophène) et de poly(styrènesulfonate) de sodium, usuellement désigné par l'acronyme PEDOT:PSS.

Par ailleurs, dans les cellules photovoltaïques à structure classique, la couche de PEDOT:PSS est disposée sous la couche active, par exemple à base de P₃HT: PCBM, tandis que dans les cellules photovoltaïques à structure inversée, la couche de PEDOT:PSS est imprimée sur la couche active et sous l'électrode supérieure servant de cathode. Les cellules photovoltaïques à structure inversée présentent l'avantage de présenter une meilleure stabilité à l'air que les cellules à structure classique, et en outre de présenter généralement des rendements de conversion plus élevés.

Par rendement de conversion d'une cellule photovoltaïque, on entend, au sens de la présente invention, le rapport de la puissance électrique maximale délivrée par la cellule sur la puissance lumineuse incidente, pour une distribution spectrale et une intensité donnée.

Il est à noter également que dans les actuels procédés de réalisation de cellules photovoltaïques organiques à structure inverse, le dépôt de l'anode sur la couche de PEDOT:PSS est majoritairement réalisé par évaporation thermique sous vide (métallisation) mais par impression jet d'encre. En effet, pour la réalisation de cellules photovoltaïques organiques à structure inversée, ce dépôt n'est pas réalisé par voie liquide dans la mesure où le PEDOT:PSS utilisé actuellement est normalement formulé pour être utilisé pour la réalisation de cellules photovoltaïques organiques à structure normale, et en particulier être déposé directement sur l'anode (couche dite HTL) .

Ainsi, la formulation de PEDOT:PSS actuellement utilisée n'est pas optimisée pour être utilisée dans des cellules photovoltaïques organiques à structure inverse. Par ailleurs, la formulation de PEDOT:PSS actuellement utilisée n'est pas non plus optimisée pour être imprimée sur la couche active.

Cependant, il a, par ailleurs, été démontré que de simples mélanges entre le PEDOT:PSS et un tensioactif peuvent permettre la réalisation de la couche interfaciale située entre la couche active et l'anode et peuvent également permettre d'améliorer considérablement les propriétés des couches obtenues (couches dites HTL), ces mélanges étant généralement utilisées pour les dépôts par voie liquide.

Il est à noter que pour obtenir des cellules photovoltaïques organiques présentant des rendements de conversion élevés, le PEDOT:PSS utilisé présente une haute conductivité. En effet, l'utilisation de PEDOT:PSS à haute conductivité présente plusieurs avantages qui sont par exemple les suivants :
- application de couches épaisses sans diminuer le rendement de conversion de la cellule photovoltaïque organique à structure inversée,
- améliorer l'extraction des charges aux électrodes en diminuant le phénomène de recombinaison à l'interface entre la couche interfaciale et l'électrode, et
- éviter la diffusion du matériau constituant l'anode qui peut traverser la couche active et créer éventuellement des courts circuits.

Par faible résistivité , on entend au sens de la présente invention une valeur de résistivité égale ou inférieure à 350 Ohm/square avec un taux de transmission dans le visible (généralement désigné par l'acronyme anglais VLT (pour « *Visible Light Transmission Level* ») de 90%.

Toutefois, quand le PEDOT:PSS est de faible résistivité, le simple mélange avec le tensioactif n'apporte aucun avantage et l'application du PEDOT:PSS par voie liquide ou par impression jet d'encre sur la couche active est difficile et non optimisée.

Il existe donc un besoin de fournir une composition de PEDOT:PSS à faible résistivité qui permet d'améliorer le rendement de conversion et la durée de vie de cellules photovoltaïques organiques à structure inversée en proposant notamment une composition de polymère conducteur capable de pallier les défauts, inconvénients et obstacles de l'art antérieur. En particulier, cette composition doit être apte notamment à être appliquée sur une couche active d'une cellule photovoltaïque organique à structure inversée, et en particulier à permettre la réalisation d'une couche interfaciale disposée entre la couche active et l'anode tout en garantissant un rendement de conversion élevé.

Par ailleurs, il existe également un besoin que cette composition soit applicable par voie liquide ou par impression jet d'encre afin de permettre la mise en oeuvre de procédés de fabrication de cellules photovoltaïques organiques à structure inverse qui soient écologiques, économiques et rapides.

En effet, il est, par ailleurs, à noter que la viscosité de la formulation d'un mélange comprenant le PEDOT-PSS représente une réelle limite au regard de son application par voie liquide. Cela est dû au fait que la grande majorité de ce type de mélange a nécessairement une viscosité très faible, ce qui est notamment due à la faible solubilité des polymères et à l'utilisation préférée de solvants sans halogènes. Ceci rend difficile la possibilité d'adaptation vers des techniques d'application par voie liquide et provoque également une baisse de la fiabilité de la technique d'impression par voie jet d'encre classique.

Pour ce faire, le demandeur a en particulier mis au point une composition de polymère conducteur présentant une faible résistivité et :
- qui est apte à être appliquée par voie liquide, et particulièrement par impression jet d'encre,
- qui est apte à être appliquée sur une large gamme de couche active dans le cadre de la réalisation d'une cellule photovoltaïque à structure inverse, et
- sur laquelle il est possible d'appliquer une électrode, en particulier une anode dans le cadre d'une cellule photovoltaïque à structure inversée.

Plus particulièrement, la présente invention a pour objet une composition de polymère conducteur présentant une viscosité inférieure à 10 mPa.s à 20°C et comprenant :
- entre 90% et 98% en volume par rapport au volume total de la composition d'une solution de Poly(3,4-ethylenedioxythiophene)-poly(styrenesulfonate) de sodium, et
- entre 2% et 10% en volume par rapport au volume total d'une composition d'additifs comprenant :
   o entre 2% et 5% en volume par rapport au volume total de l'ensemble des additifs de la composition d'additifs d'un tensioactif,
   o entre 0,8% et 2% en volume par rapport au volume total de l'ensemble des additifs de la composition d'additifs d'éthylène glycol,
   o entre 0.4% et 1% en volume par rapport au volume total de l'ensemble des additifs de la composition d'additifs éthanolamine, et
   o entre 0,8% et 2% en volume par rapport au volume total de l'ensemble des additifs de la composition d'additifs d'un glycérol.

Le tensioactif permet d'améliorer la mouillabilité, les propriétés morphologiques, mécaniques et électriques des couches PEDOT:PSS obtenues suite à l'application de cette composition de polymère conducteur.

De manière avantageuse, le ou les solvants peuvent être choisis parmi une eau déionisée et une solution tampon phosphatée saline (désignée usuellement par l'acronyme en anglais PBS pour *« phosphate Buffered Salin »).*

A titre d'exemples de Poly(3,4-éthylenedioxythiophène)-poly(styrènesulfonate) de sodium utilisables dans le cadre de la présente invention, on peut notamment citer les produits commercialisés par AGFA sous la dénomination commerciale ORGACON S315 ou par MERCK sous les dénominations commerciales 329324, 560596, 739340, 768650, 739332, 768642, 655201, 900181, 768618, et 900208, et par HERAEUS sous les marques CLEVIOS^{™} PH1000 or F HC Solar.

De manière avantageuse, le Poly(3,4-ethylenedioxythiophene)-poly(styrenesulfonate) de sodium peut présenter un pH compris entre 1.5 et 3.5.

De manière avantageuse, le tensioactif peut être un 4-(1,1,3,3-tétraméthylbutyl)phényl-polyéthylène glycol de formulet-Oct-C₆H₄-(OCH₂CH₂)ₓOH, avec x égal à 9 ou 10.

A titre d'exemples de tensioactifs utilisables dans la composition selon l'invention, on peut notamment citer le Triton X-100 commercialisé par MERCK et le Zonyl^{®} FS-300 fluorosurfactant également commercialisé par MERCK.

La présente invention a également pour objet l'utilisation de la composition selon l'invention pour réaliser une couche par impression jet d'encre.

La présente invention a également pour objet l'utilisation de la composition selon l'invention pour réaliser une couche par voie liquide.

La présente invention a encore pour objet une structure comprenant :
- une couche active ;
- une couche de polymère conducteur réalisée suite à l'application par voie liquide de la composition définie selon l'invention,

ladite structure étant caractérisée en ce que la résistivité électrique de surface de la couche de polymère conducteur comme PEDOT :PSS est comprise entre 60 à 110 Ohm/square, et
en ce que ladite couche de polymère conducteur présente une épaisseur comprise entre 30 et 50 nm.

En outre, une telle couche de polymère conducteur peut présenter un taux de transmission dans le visible de 90%.

Une telle épaisseur présente l'avantage d'avoir une couche continue, robuste, uniforme, lisse, et présentant une résistivité électrique satisfaisante.

La présente invention a encore pour objet une structure comprenant :
- une couche active ;
- une couche de polymère conducteur réalisée suite à l'application par impression jet d'encre de la composition définie selon l'invention,
ladite structure étant caractérisée en ce que
la résistivité électrique de surface de la couche de polymère conducteur est comprise entre 60 et 350 Ohm/square, et en ce que ladite couche de polymère conducteur présente une épaisseur comprise entre 30 et 150 nm. Une telle épaisseur présente l'avantage d'avoir une couche continue, robuste, uniforme, lisse, et présentant une résistivité électrique satisfaisante.

De manière avantageuse, la couche de polymère conducteur peut présenter une rugosité Ra inférieure à 5 nm.

Par rugosité de surface Ra, on entend, au sens de la présente invention, l'écart moyen arithmétique entre les creux et les pics de la surface par rapport à la ligne médiane (ou moyenne), cet écart étant estimé selon la Norme ISO 4287.

De manière avantageuse, la structure peut comprendre en outre une couche d'argent appliquée sur la couche de polymère conducteur par impression jet d'encre.

Il est à noter par ailleurs que la couche active est de préférence une couche organique comprenant soit un mélange de PV2000 et PC70BM dans l'O-xylène et le tétraline, soit un mélange de PTB7-Th et PC70BM dans l'O-xylène et le tétraline.

La présente invention a encore pour objet un procédé d'élaboration de la composition selon l'invention, comprenant les étapes suivantes :
a) filtrer un Poly(3,4-ethylènedioxythiophène)-poly(styrène-sulfonate) de sodium avec un filtre présentant une capacité de rétention comprise entre 0.2 µm et 0.8 µm ;
b) réaliser un premier mélange comprenant :
   - entre 2% et 6% en volume par rapport au volume total du premier mélange d'un tensioactif,
   - entre 1% et 4% en volume par rapport au volume total du premier mélange d'éthylène glycol,
   - entre 0.5% et 2% en volume par rapport au volume total du premier mélange d'éthanolamine,
   - entre 1% et 4% en volume par rapport au volume total du premier mélange de glycérol, et
   - entre 84 % et 95.5% en volume par rapport au volume total du premier mélange d'un solvant ;
c) chauffer le premier mélange à une température comprise entre 30 et 70°C pendant une durée comprise entre 15 et 45 min ;
d) agiter le premier mélange chauffé pendant une durée comprise entre 10 et 60 min à température ambiante ;
e) mélanger une quantité comprise entre 1 et 3 mL du Poly(3,4-ethylenedioxythiophene)-poly(styrènesulfonate) de sodium filtré avec une quantité comprise entre 10 et 50 µL du premier mélange chauffé et agité pour obtenir un deuxième mélange ;
f) chauffer le deuxième mélange à une température comprise entre 30 et 60 °C ; et
g) agiter le deuxième mélange chauffé pendant une durée comprise entre 20 et 100 min à température ambiante.

De manière avantageuse, le procédé selon l'invention peut comprendre en outre une étape h) réalisée après l'étape g) et consistant à dégazer le deuxième mélange chauffé et agité pendant 3 à 5 minutes. Ce dégazage présente l'avantage d'éliminer les gaz dissous afin d'améliorer l'application ultérieure de la composition et l'amorçage de la plupart des fluides (c'est-à-dire la mise en encre dans les chambres à encre du système jet d'encre).

De manière avantageuse, le dégazage peut s'effectuer dans un bain à ultrasons.

### EXEMPLES

### Produits

- support en verre revêtu d'une couche d'oxyde d'indium-étain (anode)
- supports flexibles en PET (Polyéthylène téréphtalate) ou en PEN (Polyéthylène (poly(éthylène 2,6-naphthalate)
- solvants de nettoyage :
   o dans le cas des supports rigides en verre : eau déionisée, Acétone, Ethanol et Isopropanol (IPA), et
   o dans le cas des substrats flexibles, ces derniers étant protégés par des films en plastiques, ils n'ont pas besoin d'un nettoyage comme dans le cas des substrats rigides ;
- premières compositions d'encres (couche interfaciale)
   o encre E11 de nanoparticules d'oxyde de Zinc synthétisée en laboratoire et dont la formulation est détaillée à l'exemple 1.
   o encre E12 de nanoparticules d'oxyde de Zinc dopé à l'aluminium (AZO) commercialisée par la société GENES'INK et synthèse réalisée en laboratoire.
- deuxièmes compositions d'encres (couche active photovoltaïque) :
   o mélange polymère E21 de [6, 6]-phenyl-C₇₁-butanoate de méthyle (commercialisé par Nano-C sous la dénomination commerciale PC70BM) et de poly(thiénol[3,4-b]-thiophène (commercialisé par Raynergytek sous la dénomination commerciale PV2000) ;
   o mélange polymère E22 de [6, 6]-phenyl-C₆₁-butanoate de méthyle (commercialisé par Nano-C sous la dénomination commerciale PC70BM) et de poly(thiénol[3,4-b]-thiophène (commercialisé par 1-Materials sous la dénomination commerciale PTB7-Th) ;
   ∘ O-xylène à titre de solvant (ortho-xylène de formule C₆H₄ (CH₃)₂) ; et
   o Tétraline (1,2,3,4-tétrahydronaphthaline) à titre d'additif.

Le polymère PV2000 du mélange E21 ou le polymère PTB7-Th du mélange E22 sont présents dans ces deuxièmes compositions d'encres à raison de 10 mg/ml.

Le rapport massique entre le polymère PV2000 du mélange E21 ou le polymère PTB7-Th du mélange E22 et le PC70BM est de 1:1.5

Le Rapport volumique entre le solvant O-xylène et l'additif Tétraline est de 97 : 3 dans ces deuxièmes compositions.

On réalise une deuxième composition d'encre en ajoutant au mélange polymère E21 ou E22 le solvant et l'additif et en maintenant ce mélange 24 heures sous agitation sur plaque chauffante à 80 °C à une vitesse de 700 RPM.
- troisièmes compositions d'encres (deuxième couche interfaciale) :
   o PEDOT:PSS commercialisé par Agfa sous la dénomination commerciale IJ1005 ou PEDOT : PSS commercialisé par Agfa sous la dénomination commerciale ORGACON S315 ;
   o Triton X-100 (4-(1,1,3,3-tétraméthylbutyl)phényl-polyéthylène glycol de formulet-Oct-C₆H₄- (OCH₂CH₂)ₓOH, x= 9-10) commercialisé par Merck à titre de détergent/tensioactif ;
   o Ethanediol (ou éthylène glycol, de formule HOCH2CH2OH) commercialisé par Merck ;
   o glycérol (1,2,3-Propanetriol ou glycérine, de formule HOCH₂CH(OH)CH2OH) commercialisé par Merck ;
   o Eau déionisée, produite en laboratoire ou bien commercialisée par la société PURELAB classic sous la marque ELGA pour l'eau.
- quatrième composition d'encres (anode) :
   ∘ Encre E41 de nanoparticules d'argent commercialisée par la société GENES'INK sous la dénomination commerciale H-CS01130), ou
   ∘ Encre E42 de nanoparticules d'argent commercialisée par la société MERCK sous la dénomination commerciale 901083, ou
   ∘ Encre de nanoparticules d'argent commercialisée par la société PV-NANOCELL, ou
   ∘ Encre de nanoparticules d'argent commercialisée par la société DUPONT, ou
   ∘ Encre de nanoparticules d'argent commercialisée par la société ANP (« Advanced Nano Products »).

### Tests

### • Mesure de la rugosité Ra

Ces mesures sont réalisées à l'aide d'un microscope à force atomique (Nanoscope III Multimode SPM de Brucker, utilisé en mode contact intermittent (ou « *tapping mode* »), avec des pointes hq:nsc15 commercialisées par MiKromasch et présentant un rayon de courbure 8 nm), les mesures ont été effectuées sur différents échantillons de cellules photovoltaïques selon l'invention et selon l'art antérieur.

### • Mesure de l'épaisseur des couches

La mesure de l'épaisseur des couches imprimées est effectuée au moyen d'un profilomètre à pointe de marque DektakXT commercialisé par BRUKER à partir d'une rayure faite avec une lame de cutter (on crée ainsi un canal ayant l'épaisseur du dépôt). Il s'agit d'un profilomètre de contact qui mesure des variations de relief grâce au déplacement vertical d'un stylet à pointe qui balaye la surface en appliquant une force de contact constante et en révèle toutes les dénivellations. L'échantillon est placé sur un plateau qui lui permet de se déplacer avec une vitesse donnée et sur une distance choisie. Les valeurs d'épaisseur présentées dans la présente demande de brevet correspondent à la moyenne de cinq mesures effectuées en six points différents d'une même marche d'un échantillon. Avant de réaliser les mesures, la longueur de la zone balayée, sa durée, la force d'appui du stylet et la plage de mesure doivent être définies.

### • Mesure de la résistivité électrique

Cette mesure est réalisée à l'aide de la technique 4 pointes, de la manière suivante :
- on place les 4 pointes alignées loin des bords de la couche à caractériser.
- Ces 4 pointes sont équidistantes les unes des autres.
- Du courant est généré par un générateur de courant entre les pointes extérieures, tandis que la tension est mesuré entre les pointes intérieures. Le report de la tension mesurée sur l'intensité qui traverse tension mesurée sur l'intensité qui traverse l'échantillon donne la résistance du tronçon entre les pointes intérieures.

### • Mesure de la viscosité :

La viscosité d'un fluide se manifeste par sa résistance à la déformation ou bien au glissement relatif de ses couches. Au cours de l'écoulement d'un fluide visqueux dans un tube capillaire par exemple, la vitesse des molécules (v) est maximale dans l'axe du tube et diminue jusqu'à s'annuler à la paroi tandis qu'entre les couches se développe un glissement relatif ; d'où l'apparition de forces tangentielles de frottement. Les forces tangentielles, dans les fluides, dépendent de la nature du fluide considéré et du régime de son écoulement.

Le viscosimètre utilisé est de type *Ubbelhode,* il est placé dans un thermostat maintenu à température constante (25 °C dans notre cas d'étude). On mesure le temps d'écoulement d'un volume constant V défini par deux traits de repères (M1 et M2) situés de part et d'autre d'un petit réservoir surmontant le capillaire.

### • Mesure du vieillissement :

Vieillissement sous éclairage permanent de type « light soacking » et vieillissement thermique à 85°C

### • Caractérisation de la morphologie :

Mesures AFM pour reproduire la topographie de surface et TEM pour valider le caractère cristallin des matériaux ainsi que les tailles de nanoparticules présentes au niveau des couches.

### • Rendement de conversion

Le rendement de conversion est le rapport de la puissance générée et de la puissance du rayonnement solaire incident qui est normalisée à 100 mW/cm² pour un spectre AM1.5.

### EXEMPLE 1 : obtention d'un premier exemple de première composition d'encre E11 pour couche interfaciale

### 1.2 Synthèse du ZnO par la technique Polyol^{[4]}

### Matériels utilisés:

Deux ballons, Colonne à Brome, Bain d'huile, Bouteille d'Argon, filtre à seringue, plaque chauffante et agitateur magnétique, bain à ultrason, imprimante Ardeje A100, imprimante Ardeje OD100, tête d'impression des marques : KONICA, RICOH, SEIKO, XAAR, DIMATIX, HP, EPSON.

### Procédure :

- En premier lieu, on pèse une quantité de 2,207 g de KOH dans un ballon de 250 mL. Ensuite on ajoute 115 mL de méthanol. Dans un autre ballon plus grand, on ajoute 4.101g de l'acétate de zinc avec 210 mL de méthanol sous agitation puis on ajoute 115 ml d'eau.
- Puis, on fixe ce grand ballon dans un bain d'huile (ou d'eau) sous agitation et sous argon à 60°C sur une plaque chauffante et sous agitation.
- Par ailleurs, le KOH est dissous dans un bain ultrason pour l'ajouter ensuite goutte à goutte dans ce ballon.
- Nous observerons un changement de couleur de transparent à opaque. Après quelques minutes, la solution redevient transparente.
- Le mélange est ensuite encore agité pendant 3 heures, à l'issue desquelles une suspension blanche de ZnO s'est formée.

### 1.3 Fabrication de l'encre E11 à partir des nanoparticules de ZnO synthétisées

- L'oxyde zinc ZnO obtenu à l'issue de la technique Polyol à l'issue de l'exemple 1.1 est refroidi en bain froid et les particules de ZnO sont séparées par centrifugation (12 min et 7800 tr/ min) puis dispersées dans le butanol utilisant l'éthylène glycol comme surfactant.
- On obtient une encre E11 de particules de ZnO ayant une concentration en nanoparticules de 4 mg/ml.
- Avant l'impression par jet d'encre, l'encre E11 est préalablement filtrée avec un filtre de 0.45 micromètres en acétate de cellulose (AC).

### EXEMPLE 2 : obtention d'un deuxième exemple de première composition d'encre E12 pour couche interfaciale

On utilise l'encre de nanoparticules d'oxyde de Zinc dopé à l'aluminium (AZO) commercialisée par la société GENES'INK de la manière suivante : avant l'impression par jet d'encre, l'encre est préalablement mise dans un bain ultrason pendant 2 minutes à température ambiante, puis filtrée avec un filtre de 0.45 micromètres en acétate de cellulose. On obtient l'encre E12.

### EXEMPLE 3 : obtention d'un troisième exemple de première composition d'encre E13 pour couche interfaciale

### 3.1 Synthèse de nanoparticules d'AZO

Cette synthèse se fait par le protocole suivant, conformément à celui décrit dans la publication scientifique [3] :
- On introduit de l'acétate de zinc, de l'isopropylate d'aluminium et de l'eau distillée dans un ballon contenant de l'éthanol anhydre.
- Après chauffage à 80°C pendant 30 minutes, de l'hydroxyde de potassium dispersé dans l'éthanol est ajouté goutte à goutte au ballon en chauffant à 80°C pendant 16 heures : des nanoparticules d'AZO sont ainsi synthétisées.
- Ces nanoparticules sont ensuite séparées de la solution par centrifugation et dispersées dans un solvant à base d'alcool utilisant l'éthanolamine (EA).
- Par cette méthode, des nanoparticules d'AZO NCs (acronyme anglais pour : « *Aluminium Doped Zinc Oxyde nano-crystals* ») à des niveaux de dopage Al allant de 0% (référence non dopée) jusqu'à 0.8% ont été produites en variant le rapport initial du précurseur d'isopropylate d'aluminium par rapport à l'acétate de zinc, et en gardant tous les autres paramètres constants.

### 3.2 Procédure de fabrication de l'encre E12 à partir des nanoparticules d'AZO synthétisées

- L'AZO obtenu à l'issue de la technique Polyol-à l'issue de l'exemple 3.1 est refroidi en bain froid et les particules d'AZO sont séparées par centrifugation (12 min et 7800 tr/ min) puis dispersées dans le butanol utilisant l'éthylène glycol comme surfactant.
- On obtient une encre E12 de particules d'AZO ayant une concentration en nanoparticules de 2 mg/ml.
- Avant l'impression par jet d'encre, l'encre E12 est préalablement filtrée avec un filtre de 0.45 micromètres en acétate de cellulose.

### EXEMPLE 4 : obtention de deuxièmes compositions d'encre E21 et E22 pour couche active photovoltaïque

Selon que l'on utilise du PC70BM associé à PV2000 ou du PC70BM associé à du PTB7-Th, on obtient respectivement les compositions d'encre E21 et E22, dont les compositions sont détaillées dans le tableau 1 ci-après :

**Tableau 1 :**

| Composition | E21 | E22 |
|---|---|---|
| PC70BM | 15 mg | 15 mg |
| PTB7-Th | 10 mg | |
| PV2000 | | 10 mg |
| O-xylène | 1 mL | 1 mL |
| Tétraline | 60 microlitres | 60 microlitres |

La composition d'encre E21 est obtenue comme suit :
- 10 mg PTB7-th mélangés avec 15 mg de PC70BM (correspondant à un rapport massique 1 :1.5) dans 1 millilitre de o-xylène et 60 microlitres de tétraline.
- Le mélange est mis sous agitation magnétique sur plaque chauffante à 80°C pendant 24 heures.
- Avant l'impression, l'encre est préalablement filtrée avec un filtre 0.45 micromètres en AC.
- Les couches imprimées subissent ensuite un recuit thermique sur plaque chauffante à 85 °C pendant 2 minutes.

La composition d'encre E22 est obtenue comme suit :
- 10 mg PV2000 mélangés avec 15 mg de PC70BM (correspondant à un rapport massique 1 : 1.5) dans 1 millilitre de o-xylène et 60 microlitres de tétraline.
- Le mélange est mis sous agitation magnétique sur une plaque chauffante à 80°C pendant 24 heures.
- Avant l'impression par voie jet d'encre, l'encre E22 est filtrée avec un filtre 0.45 micromètres en AC.

Après impression jet d'encre d'E12 ou E22, on obtient des couches actives photovoltaïques qui, une fois imprimées sont soumises à un recuit thermique sur plaque chauffante à 85 °C pendant 2 minutes.

### EXEMPLE 5 : obtention de troisièmes compositions d'encre E31 et E32 pour deuxième couche interfaciale

Ces troisièmes compositions d'encre E31 et E32 pour deuxième couche interfaciale sont obtenues comme suit :
- on filtre le PEDOT:PSS avec un filtre 0.45 µm ;
- on mélange 500 µl de Triton X-100 (a) avec 200 µl Ethylène Glycol (b), 200 µl Glycérol (c) et 100 µl Ethanolamine (d) dans 9 ml d'eau déionisée (e) ;
- on met le mélange ainsi obtenu sous agitation magnétique à 50°C sur plaque chauffante pendant 30 minutes, puis sous agitation magnétique à température ambiante pendant 20 minutes ;
- on mélange le PEDOT:PSS initialement filtré avec mélange ainsi obtenu après agitation, dans les proportions suivantes : 30 µl de mélange des 4 additifs dans l'eau déionisée pour 1 ml de PEDOT:PSS ; on met le mélange résultant (avec PEDOT:PSS) sous agitation magnétique sur plaque chauffante à température ambiante pendant 1 heure au minimum ; et
- on dégaze la solution finale ainsi obtenue E31 pendant 3 à 5 minutes dans un bain ultrason avant l'impression.

Selon que l'on utilise le PEDOT: PSS IJ1005 ou le PEDOT:PSS ORGACON S315, on obtient respectivement les compositions d'encre E31 et E32, dont les compositions sont détaillées dans les deux tableaux 2 et 3 ci-après :

**Tableau 2 :**

| Composition | | Solution X (a+b+c+d) |
|---|---|---|
| a-Triton x-100 | A | 500 µL |
| b-Ethylène Glycol | B | 200 µL |
| c-Glycérol | c | 200 µL |
| d-Ethanolamine | D | 100 µL |
| e-Eau déionisée | E | 9 mL |

**Tableau 3 :**

| Composition | E31 | E32 |
|---|---|---|
| IJ1005 | 1 mL | |
| Orgacon S315 | | 1 mL |
| Solution X a) +b) +c) +d) | 30 µL | 30 µL |

### EXEMPLE 6 : obtention d'exemples de cellules OPV selon l'invention

On réalise des cellules OPV conformes à l'invention selon le procédé suivant :

### Cas des substrats rigides :

- Nettoyage du substrat rigide en verre avec couche ITO structurée par trempage successif dans 4 bains de nettoyage différents :
   o Bain 1 : Eau déionisée à 20-40 °C pendant 10-15 minutes,
   o Bain 2 : Acétone à 20-40 °C pendant 10-15 minutes,
   o Bain 3 : Ethanol à 20-40 °C pendant 10-15 minutes,
   o Bain 4 : Isopropanol à 20-40 °C pendant 10-15 minutes ;
- Impression de l'encre E11, E12, ou E13 suivi d'un recuit à 85 °C pendant 5 minutes ;
- Impression de l'encre de la couche active E21 ou E22 suivi d'un recuit à 85 °C pendant 2 minutes ;
- Nettoyage de la couche active E21 ou E22 avec un alcool (Ethanol, Butanol, isopropanol) ;
- Impression de l'encre E31 ou E32, suivi d'un recuit à 120 °C pendant 2 minutes ;
- Nettoyage de la couche E31 ou E32 avec un alcool (Ethanol, Butanol, Isopropanol) ;
- Impression de l'encre d'Ag E41 (de Genes'Ink) ou E42 (de Merck), suivie d'un recuit à 135 °C pendant 5-8 minutes.

### Cas des substrats flexibles :

- Le substrat ITO/PET est protégé par deux films en plastique sur les deux faces:
   ∘ on colle ce substrat avec du scotch double face sur une lame de verre ayant la même dimension ;
   o On enlève ensuite le film plastique qui couvre la face ITO du substrat ;
- Impression de l'encre E11 (ou E12) suivi d'un recuit à 85°C pendant 5 minutes ;
- Impression de l'encre de la couche active E21ou E22 suivi d'un recuit à 85 °C pendant 2 minutes ;
- Nettoyage de la couche active E21ou E22 avec un alcool (Ethanol, Butanol, isopropanol) ;
- Impression de l'encre E31 ou E32 suivi d'un recuit à 120 °C pendant 2 minutes ;
- Nettoyage de la couche E31 ou E32 avec un alcool (méthanol, éthanol, butanol, isopropanol) ;
- Impression de l'encre E41 ou E42, suivie d'un recuit à 135 °C pendant 5 à 8 minutes ;
- Détacher la cellule photovoltaïque ainsi obtenue du film en plastique.

On obtient à l'issue du procédé de fabrication les cellules suivantes, qui sont récapitulées le tableau 4 ci-après :

**Tableau 4 :**

| Cellules OPV selon l'invention | Composition de la première couche interfaciale 4 | Composition de la couche active photovoltaïque 5 | Nettoyage couche active | Composition de la deuxième couche interfaciale 6 | Nettoyage de la couche interfaciale |
|---|---|---|---|---|---|
| C1 | E11 | E21 | Oui | E31 | oui |
| C2 | E12 | E21 | Oui | E31 | oui |
| C3 | E11 | E22 | Oui | E31 | oui |
| C4 | E12 | E22 | Oui | E31 | oui |
| C5 | E11 | E21 | Oui | E32 | oui |
| C6 | E12 | E21 | Oui | E32 | oui |
| C7 | E11 | E22 | Oui | E32 | oui |
| C8 | E12 | E22 | Oui | E32 | oui |
| C9 | E11 | E21 | Non | E31 | non |
| C10 | E12 | E21 | Non | E31 | non |
| C11 | E11 | E22 | Non | E31 | non |
| C12 | E12 | E22 | Non | E31 | non |
| C13 | E11 | E21 | Non | E32 | non |
| C14 | E12 | E21 | Non | E32 | non |
| C15 | E11 | E22 | Non | E32 | non |
| C16 | E12 | E22 | Non | E32 | non |

### EXEMPLE 7 : obtention d'exemples de cellules OPV conformes à l'art antérieur/témoins

On réalise des cellules OPV conformes à l'art antérieur/témoins selon le procédé suivant :
1) Les substrats ITO (achetés chez Lumtec, 15 Ohm/square²) ont été soigneusement nettoyés par sonication dans l'eau déionisée l'acétone, l'éthanol puis dans l'IPA (10 minutes par bain) ;
2) Une solution à base de nanoparticules de ZnO (où d'AZO) dans l'IPA et de l' éthanolamine à 0,2% (v / v) a été déposée par centrifugation (ou « *spin coating* ») à 1500 tr / min pendant 1 min et séchées à 80 ° C pendant 5 min sur plaque chauffante ;
3) PTB7-Th (ou PV2000) et PC70BM sont mélangés avec un rapport massique de 1: 1.5 dans l'O-xylène comme solvant et la tétraline comme additif avec une concentration de 10 mg/ml en polymère (le ratio entre solvant et additif est 97 :3 v/v). Une couche ayant une épaisseur nominale de 90-100 nm, a été déposée par centrifugation (ou « *spin coating* ») à 2 700 tr / min pendant 2 min ;
4) Une couche fine de poly (3,4-PEDOT: PSS) (S315) a été déposée par centrifugation (ou « *spin coating* ») sur la couche organique à la vitesse de 3000 tr / min pendant 60 s, puis chauffée sur une plaque chauffante à 120 ° C pendant 5 minutes ;
5) Pour la cathode, des échantillons ont été placés dans un évaporateur MBRAUN à l'intérieur d'une boîte à gants, dans lequel des électrodes métalliques Al (100 nm) ont été évaporées thermiquement sous une pression de 2 x 10-7 Torr à travers un masque.

### EXEMPLE 8 : caractérisation des cellules OPV obtenues aux exemples 6 et 7

Les différentes cellules OPV, selon l'invention et témoins, ont été caractérisées selon les tests indiqués précédemment et les résultats de ces caractérisations dans le tableau 5 ci-après.

**Tableau 5 : (VLT : visible light transmission)**

| Cellules OPV selon l'invent ion | Résistivité électrique 95 % VLT at 550 nm | Résistivité électrique 90 % VLT at 550 nm | Rendement de conversion (%) pour une surface de 2 cm² à 3,5 cm² | Épaisseur de couches |
|---|---|---|---|---|
| C2 | 150 - 200 Ohm/square, | 60 - 80 Ohm/square, | 4 - 6.2 % | 80-100 nm |
| C4 | 150 - 200 Ohm/square, | 60 - 80 Ohm/square, | 3.5 - 5 % | 80-100 nm |
| C6 | 200 - 250 Ohm/square, | 80 - 100 Ohm/square, | 3 - 5 % | 80-100 nm |
| C8 | 200 - 250 Ohm/square, | 80 - 100 Ohm/square, | 3.5 - 5 % | 80-100 nm |
| C10 | 250 - 300 Ohm/square, | 90 - 110 Ohm/square, | 3 - 5 % | 80-100 nm |
| C12 | 250 - 300 Ohm/square, | 90 - 110 Ohm/square, | 2.5 - 4 % | 80-100 nm |
| C14 | 300 - 350 Ohm/square, | 100 - 110 Ohm/square, | 2.5 - 4% | 80-100 nm |
| C16 | 300 - 350 Ohm/square, | 100 - 110 Ohm/square, | 3 - 3.5 % | 80-100 nm |

Les cellules OPV selon l'invention C2 à C16 montrent que la problématique d'impression de la couche HTL en matériau PEDOT :PSS, d'une cellule photovoltaïque est résolu : est en mesure de réaliser une cellule, ou un module organique composé de 4 couches imprimées sur une première électrode transparente conductrice présente sur le substrat souple plastique ou rigide verre, ou composé de 5 couches imprimées sur un substrat souple plastique ou rigide verre vierge de tout matériau.

L'invention consiste à formuler une solution de PEDOT :PSS compatible avec le procédé d'impression jet d'encre. Cette formulation nous permet de mettre en oeuvre avantageusement un PEDOT :PSS de haute conductivité classiquement utilisé en couche HTL déposée sur ITO ou pour remplacer cette électrode, pour obtenir une couche HTL déposée sur la couche active organique.

Le procédé d'impression jet d'encre combiné à cette formulation nous permet de contrôler l'épaisseur de couche imprimée, pour optimiser les caractéristiques électriques et optiques du matériau, mais aussi de sa morphologie qui améliore l'extraction des charges aux électrodes en diminuant le phénomène de recombinaison à l'interface entre la couche interfaciale et l'électrode et avec une ségrégation verticale favorable au transport des charges. Cela nous permet aussi d'obtenir des couches épaisses sans diminuer le rendement de conversion, ce qui d'un point de vue de procédé favorise la répétabilité et la stabilité. Les rendements de conversion des modules réalisés à l'aide de la présente invention restent uniques à ce jour. Il est ainsi possible de réaliser :
- une série de 20 modules de 6 cellules interconnectées, chaque module composé de 4 couches imprimées sur une première couche d'ITO structurée sur verre, représentant 3,5 cm² de couche active au total, avec un rendement moyen de conversion de 5,7% et un maximum de 6,2% sous 1 SUN AM 1.5 ;
- une série de 5 modules de cellules interconnectées, chaque module composé de 4 couches imprimées sur une première couche d'ITO structurée sur PET flexible, représentant 3,5 cm² de couche active au total, avec un rendement moyen de conversion de 3,5% et un maximum de 4,1% sous 1 SUN AM 1.5

### LISTE DES REFERENCES

[1] Sharaf Sumaiya, Kamran Kardel, and Adel El-Shahat. "Organic Solar Cell by Inkjet Printing - An Overview." 53, Georgia, USA : Technologies, 2017, Vol. 5.
[2] Peng, X., Yuan, J., Shen, S., Gao, M., Chesman, A. S. R., & Yin, H. (2017). "Perovskite and Organic Solar Cells Fabricated by Inkjet Printing: Progress and Prospects", Adv. Funct. Mater. 2017, 1703704.
[3] Demande de brevet Européen EP2960957 de DRACULA TECHNOLOGIES, déposée le 25 juin 2015 et publiée le 30 décembre 2015.
[4] S.Ben Dkhil, D. Duché, M. Gaceur, A. K. Thakur, F. Bencheikh Aboura, L. Escoubas, J.-J. Simon, A. Guerrero, J. Bisquert, G. Garcia-Belmonte, Q. Bao, M. Fahlman, C. Videlot-Ackermann, O. Margeat, J. Ackermann, "ZnO Optical Spacers in Highly Efficient Polymer Solar Cells", Adv. Energy Mater. 2014, 1400805.
[5] T.M. EFFENHUISEN ET AL. : "High efficiency, fully inkjet printed organic solar cells with freedom of design", J.MATER.CHEM.A, 3 (2015) 7255-7262.

## Revendications

1. Composition de polymère conducteur, ladite composition présentant une viscosité inférieure à 10 mPa.s à 20°C et comprenant :
- entre 90% et 98% en volume par rapport au volume total de ladite composition d'une solution de Poly(3,4-ethylènedioxythiophene)-poly(styrènesulfonate) de sodium, et
- entre 2% et 10% en volume par rapport au volume total d'une composition d'additifs comprenant :
o entre 2% et 5% en volume par rapport au volume total de l'ensemble des additifs de la composition d'additifs d'un tensioactif,
o entre 0,8% et 2% en volume par rapport au volume total de l'ensemble des additifs de la composition d'additifs d'éthylène glycol,
o entre 0.4% et 1% en volume par rapport au volume total de l'ensemble des additifs de la composition d'additifs éthanolamine, et
o entre 0,8% et 2% en volume par rapport au volume total de l'ensemble des additifs de la composition d'additifs d'un glycérol.

2. Composition selon la revendication 1, selon laquelle lesdits un ou plusieurs solvants sont choisis parmi l'éthanol, l'éthylène glycol, une eau déionisée et une solution tampon phosphatée saline.

3. Composition selon l'une quelconque des revendications 1 et 2, selon laquelle ledit Poly(3,4-éthylènedioxythiophène)-poly(styrènesulfonate) de sodium présente un pH compris entre 1,5 et 3,5.

4. Composition selon l'une quelconque des revendications 1 à 3, selon laquelle ledit tensioactif est un 4-(1,1,3,3-tétraméthylbutyl)phényl-polyéthylène glycol de formulet-Oct-C₆H₄-(OCH₂CH₂)ₓOH, avec x égal à 9 ou 10.

5. Utilisation de la composition selon l'une quelconque des revendications 1 à 4 pour réaliser une couche par impression jet d'encre.

6. Utilisation de la composition selon l'une quelconque des revendications 1 à 5 pour réaliser une couche par voie liquide.

7. Structure comprenant :
- une couche active ;
- une couche de polymère conducteur réalisée suite à l'application par voie liquide de la composition définie par l'une quelconque des revendications 1 à 4,
ladite structure étant **caractérisée en ce que** la résistivité électrique de surface de la couche de polymère conducteur est comprise entre 60 à 110 Ohm/square, et
**en ce que** ladite couche de polymère conducteur présente une épaisseur comprise entre 30 et 50 nm.

8. Structure comprenant :
- une couche active ;
- une couche de polymère conducteur réalisée suite à l'application par impression jet d'encre de la composition définie par l'une quelconque des revendications 1 à 4,
ladite structure étant **caractérisée en ce que** la résistivité électrique de surface de la couche de polymère conducteur est comprise entre 60 et 350 Ohm/square, et
**en ce que** ladite couche de polymère conducteur présente une épaisseur comprise entre 30 et 150 nm.

9. Structure selon l'une quelconque des revendications 7 ou 8, selon laquelle ladite couche de polymère conducteur présente une rugosité Ra inférieure à 5 nm.

10. Structure selon l'une quelconque des revendications 7 à 9, comprenant en outre une couche d'argent appliquée sur ladite couche de polymère conducteur.

11. Procédé d'élaboration de la composition définie selon l'une quelconque des revendications 1 à 4, ledit procédé comprenant les étapes suivantes :
a) filtrer un Poly(3,4-ethylènedioxythiophène)-poly(styrènesulfonate) de sodium avec un filtre présentant une capacité de rétention comprise entre 0.2 µm et 0.8 µm ;
b) réaliser un premier mélange comprenant :
- entre 2% et 6% en volume par rapport au volume total du premier mélange d'un tensioactif,
- entre 1% et 4% en volume par rapport au volume total du premier mélange d'éthylène glycol,
- entre 0.5% et 2% en volume par rapport au volume total du premier mélange d'éthanolamine,
- entre 1% et 4% en volume par rapport au volume total du premier mélange de glycérol, et
- entre 84 % et 95.5% en volume par rapport au volume total du premier mélange d'un solvant ;
c) chauffer le premier mélange à une température comprise entre 30 et 70°C pendant une durée comprise entre 15 et 45 min ;
d) agiter le premier mélange chauffé pendant une durée comprise entre 10 et 60 min à température ambiante ;
e) mélanger une quantité comprise entre 1 et 3 mL du Poly(3,4-ethylenedioxythiophene)-poly(styrènesulfonate) de sodium filtré avec une quantité comprise entre 10 et 50 µL du premier mélange chauffé et agité pour obtenir un deuxième mélange ;
f) chauffer le deuxième mélange à une température comprise entre 30 et 60 °C ; et
g) agiter le deuxième mélange chauffé pendant une durée comprise entre 20 et 100 min à température ambiante.

12. Procédé selon la revendication 11, comprenant en outre une étape h) réalisée après l'étape g) et consistant à dégazer ledit deuxième mélange chauffé et agité pendant 3 à 5 minutes.

13. Procédé selon la revendication 12, selon lequel ledit dégazage s'effectue dans un bain à ultrasons.

## Patentansprüche

1. Leitfähige Polymerzusammensetzung, wobei die Zusammensetzung eine Viskosität von weniger als 10 mPa.s bei 20°C aufweist und umfaßt:
- zwischen 90 und 98 Volumenprozent, bezogen auf das Gesamtvolumen der Zusammensetzung, einer Lösung von Natriumpoly(3,4-Ethylendioxythiophen)-poly(styrolsulfonat), und
- zwischen 2 und 10 Volumenprozent, bezogen auf das Gesamtvolumen, einer Zusatzstoffzusammensetzung, die :
o zwischen 2 und 5 Volumenprozent, bezogen auf das Gesamtvolumen aller Additive in der Additivzusammensetzung eines Tensids,
o zwischen 0,8 und 2 Volumenprozent, bezogen auf das Gesamtvolumen aller Zusatzstoffe in der Zusatzstoffzusammensetzung von Ethylenglykol,
o zwischen 0,4 und 1 Volumenprozent, bezogen auf das Gesamtvolumen aller Zusatzstoffe in der Zusatzstoffzusammensetzung von Ethanolamin, und
o zwischen 0,8 und 2 Volumenprozent, bezogen auf das Gesamtvolumen aller Zusatzstoffe in der Zusatzstoffzusammensetzung eines Glycerins.

2. Zusammensetzung nach Anspruch 1, wobei das eine oder die mehreren Lösungsmittel ausgewählt sind aus Ethanol, Ethylenglykol, deionisiertem Wasser und einer Salzphosphatpufferlösung.

3. Zusammensetzung nach einem der Ansprüche 1 und 2, wobei das Natriumpoly(3,4-ethylendioxythiophen)-poly(styrolsulfonat) einen pH-Wert zwischen 1,5 und 3,5 aufweist.

4. Zusammensetzung nach einem der Ansprüche 1 bis 3, wobei das Tensid ein 4-(1,1,3,3-Tetramethylbutyl)phenyl-Polyethylenglykol der Formel -Oct-C H₆₄ -(OCH₂ CH )₂ₓ OH ist, wobei x 9 oder 10 ist.

5. Verwendung der Zusammensetzung nach einem der Ansprüche 1 bis 4 zur Herstellung einer Schicht durch Tintenstrahldruck.

6. Verwendung der Zusammensetzung nach einem der Ansprüche 1 bis 5 zur Herstellung einer Schicht auf flüssigem Wege.

7. Struktur bestehend aus :
- eine aktive Schicht;
- eine leitfähige Polymerschicht, die durch Aufbringen der Zusammensetzung nach einem der Ansprüche 1 bis 4 in flüssiger Form hergestellt wird,
wobei die Struktur **dadurch gekennzeichnet ist, dass** der elektrische Oberflächenwiderstand der leitfähigen Polymerschicht zwischen 60 und 110 Ohm/Quadrat liegt, und
dass die besagte leitfähige Polymerschicht eine Dicke zwischen 30 und 50 nm aufweist.

8. Struktur bestehend aus :
- eine aktive Schicht;
- eine leitfähige Polymerschicht, die durch Aufbringen der in einem der Ansprüche 1 bis 4 definierten Zusammensetzung mittels Tintenstrahldruck hergestellt wird,
wobei die Struktur **dadurch gekennzeichnet ist, dass** der elektrische Oberflächenwiderstand der leitfähigen Polymerschicht zwischen 60 und 350 Ohm/Quadrat liegt, und
dass die besagte leitfähige Polymerschicht eine Dicke zwischen 30 und 150 nm aufweist.

9. Struktur nach einem der Ansprüche 7 oder 8, wobei die leitfähige Polymerschicht eine Rauhigkeit Ra von weniger als 5 nm aufweist.

10. Struktur nach einem der Ansprüche 7 bis 9, die ferner eine auf die leitfähige Polymerschicht aufgebrachte Silberschicht umfasst.

11. Verfahren zur Herstellung der in einem der Ansprüche 1 bis 4 definierten Zusammensetzung, wobei das Verfahren die folgenden Schritte umfasst:
a) ein Natrium-Poly(3,4-ethylendioxythiophen)-poly(styrolsulfonat) mit einem Filter mit einem Rückhaltevermögen zwischen 0,2 µm und 0,8 µm filtern;
b) eine erste Mischung herstellen, bestehend aus :
- zwischen 2 und 6 Volumenprozent, bezogen auf das Gesamtvolumen der ersten Mischung eines Tensids,
- zwischen 1 und 4 Volumenprozent, bezogen auf das Gesamtvolumen der ersten Ethylenglykolmischung,
- zwischen 0,5 und 2 Volumenprozent, bezogen auf das Gesamtvolumen der ersten Ethanolaminmischung,
- zwischen 1 und 4 Volumenprozent, bezogen auf das Gesamtvolumen der ersten Glycerinmischung, und
- zwischen 84 und 95,5 Volumenprozent, bezogen auf das Gesamtvolumen der ersten Lösungsmittelmischung;
c) Erhitzen Sie die erste Mischung 15 bis 45 Minuten lang auf eine Temperatur zwischen 30 und 70 °C;
d) Rühren Sie die erste erwärmte Mischung 10 bis 60 Minuten lang bei Raumtemperatur;
e) 1 bis 3 mL des filtrierten Natriumpoly(3,4-ethylendioxythiophen)-poly(styrolsulfonat) mit 10 bis 50 µL der ersten erhitzten und gerührten Mischung mischen, um eine zweite Mischung zu erhalten;
f) Erhitzen der zweiten Mischung auf eine Temperatur zwischen 30 und 60 °C; und
g) Die zweite erwärmte Mischung 20 bis 100 Minuten lang bei Raumtemperatur rühren.

12. Verfahren nach Anspruch 11, das ferner einen Schritt h) umfasst, der nach Schritt g) durchgeführt wird und darin besteht, die zweite erhitzte und gerührte Mischung 3 bis 5 Minuten lang zu entgasen.

13. Verfahren nach Anspruch 12, wobei die Entgasung in einem Ultraschallbad durchgeführt wird.

## Claims

1. A conductive polymer composition, said composition having a viscosity of less than 10 mPa.s at 20°C and comprising :
- between 90% and 98% by volume based on the total volume of said composition of a solution of sodium poly(3,4-ethylenedioxythiophene)-poly(styrenesulfonate), and
- between 2% and 10% by volume based on the total volume of an additive composition comprising :
o between 2% and 5% by volume based on the total volume of all additives in the additive composition of a surfactant,
o between 0.8% and 2% by volume based on the total volume of all additives in the additive composition of ethylene glycol,
o between 0.4% and 1% by volume based on the total volume of all additives in the additive composition of ethanolamine, and
o between 0.8% and 2% by volume based on the total volume of all additives in the additive composition of a glycerol.

2. A composition according to claim 1, wherein said one or more solvents are selected from ethanol, ethylene glycol, deionized water and a saline phosphate buffer solution.

3. A composition according to any one of claims 1 and 2, wherein said sodium poly(3,4-ethylenedioxythiophene)-poly(styrenesulfonate) has a pH between 1.5 and 3.5.

4. A composition according to any one of claims 1 to 3, wherein said surfactant is a 4-(1,1,3,3-tetramethylbutyl)phenyl-polyethylene glycol of the formula -Oct-C₆H₄-(OCH₂CH₂)ₓOH, where x is 9 or 10.

5. Use of the composition according to any one of claims 1 to 4 for making a layer by ink jet printing.

6. Use of the composition according to any one of claims 1 to 5 for making a layer by liquid means.

7. Structure comprising :
- an active layer;
- a conductive polymer layer produced by application by liquid means of the composition defined by any one of claims 1 to 4,
said structure being **characterized in that** the surface electrical resistivity of the conductive polymer layer is between 60 and 110 Ohm/square, and
**in that** the said conductive polymer layer has a thickness of between 30 and 50 nm.

8. Structure comprising :
- an active layer;
- a conductive polymer layer produced by application by inkjet printing of the composition defined by any one of claims 1 to 4,
said structure being **characterized in that** the surface electrical resistivity of the conductive polymer layer is between 60 and 350 Ohm/square, and
**in that** the said conductive polymer layer has a thickness of between 30 and 150 nm.

9. A structure according to any one of claims 7 or 8, wherein said conductive polymer layer has a roughness Ra of less than 5 nm.

10. A structure according to any one of claims 7 to 9, further comprising a layer of silver applied on said conductive polymer layer.

11. A method of producing the composition defined in any one of claims 1 to 4, said method comprising the following steps:
a) filter a sodium poly(3,4-ethylenedioxythiophene)-poly(styrenesulfonate) with a filter having a retention capacity of between 0.2 µm and 0.8 µm;
b) make a first mixture comprising :
- between 2% and 6% by volume based on the total volume of the first mixture of a surfactant,
- between 1% and 4% by volume based on the total volume of the first mixture of ethylene glycol,
- between 0.5% and 2% by volume based on the total volume of the first mixture of ethanolamine,
- between 1% and 4% by volume based on the total volume of the first mixture of glycerol, and
- between 84 % and 95.5 % by volume based on the total volume of the first mixture of a solvent;
c) Heat the first mixture to a temperature between 30 and 70°C for 15 to 45 minutes;
d) Stir the first heated mixture for 10 to 60 minutes at room temperature;
e) Mix 1 to 3 mL of the filtered sodium poly(3,4-ethylenedioxythiophene)-poly(styrenesulfonate) with 10 to 50 µL of the first heated and stirred mixture to obtain a second mixture;
f) heat the second mixture to a temperature between 30 and 60 °C; and
g) Stir the second heated mixture for 20 to 100 minutes at room temperature.

12. Process according to claim 11, further comprising a step h) carried out after step g) and consisting of degassing said second heated and stirred mixture for 3 to 5 minutes.

13. A method according to claim 12, wherein said degassing is carried out in an ultrasonic bath.
